Europäisches Patentamt

European Patent Office

Office européen des brevets

(11) Publication number: 0 297 830 B1

# EUROPEAN PATENT SPECIFICATION

(45) Date of publication of patent specification: 23.12.92

(51) Int. Cl.⁵: **C25D 5/12**, C23C 14/34, C23C 4/10, C23C 16/34, C23C 28/00

(21) Application number: 88305869.5

(22) Date of filing: 28.06.88

(54) **Process for producing gold-colored coinage.**

(30) Priority: 30.06.87 CA 540903

(43) Date of publication of application:
04.01.89 Bulletin 89/01

(45) Publication of the grant of the patent:
23.12.92 Bulletin 92/52

(84) Designated Contracting States:
AT BE CH DE ES FR GB GR IT LI LU NL SE

(56) References cited:
DD-A- 244 150
DE-A- 3 425 467

PATENT ABSTRACTS OF JAPAN, unexamined applications, C. field, vol. 10, no. 185, June 27, 1986 THE PATENT OFFICE JAPANESE GOVERNMENT, page 101 C 357

IBM TECHNICAL DISCLOSURE BULLETIN, vol 25, no. 11A, April 1983 J.J. CUOMO et al. "Fabrication of ZrN Coatings" page 5506

(73) Proprietor: INCO LIMITED
Royal Trust Tower Toronto-Dominion Centre
Toronto Ontario, M5K 1N4(CA)

(72) Inventor: **Babjak, Juraj**
**671 Louis Drive**
**Mississauga Ontario L5B 2V4(CA)**
Inventor: **Bell, James Alexander Evert**
**3217 Shoreline Drive**
**Oakville Ontario L6L 5Y9(CA)**
Inventor: **Bradford, Raymond Augustus**
**216 Andrew Park**
**Woodbridge Ontario L4L 1G5(CA)**
Inventor: **Conard, Bruce Randolph**
**153 Balsam Drive**
**Oakville Ontario L6J 3X4(CA)**
Inventor: **Hope, Douglas Albert**
**2356 Wadding Crescent**
**Mississauga Ontario L5K 1Z3(CA)**

(74) Representative: **Hedley, Nicholas James Matthew et al**
**Stephenson Harwood One, St. Paul's Churchyard**
**London EC4M 8SH(GB)**

## Description

The present invention is concerned with coins, tokens, medals, medallions and the like and more particularly with coins, medals, tokens and the like which are of a golden color.

BACKGROUND OF THE ART AND PROBLEM

Coinage systems in many jurisdictions generally follow a pattern such that small denomination coins are relatively small and made of copper or brass and large denomination coins are likely made of white-colored metal and approximately vary directly in size with value. There is a tendency for coins of large denomination to be relatively bulky. When a coin reaches a certain size, it tends to lose favor with the public. As an example, in the United States of America in 1985 for each 100 quarters ($0.25) or dimes ($0.10) struck by the U.S. Mint, only about 3 half-dollars ($0.50) were struck. Thus, the maximum size limitation of coins arbitrarily set by public demand appears to be about the size of a U.S. half-dollar. A dollar coin, twice the weight of a half-dollar would likely not be used by the public. This was recognized by the U.S. Government, which, starting in 1979 minted a cupro-nickel clad dollar coin bearing the likeness of Susan B. Anthony. This coin, slightly larger than a quarter, was not accepted by the public apparently because it was too easily confused with a quarter. In 1985, the last year for which statistics are available to the inventors, no non-silver dollar coins were struck by the U.S. Mint.

Given the value of gold and silver on the open market today, it is impossible to justify the use of either of these metals for common circulating coinage. For example, assume silver is valued at $5.00 U.S. per troy ounce on the wholesale market, a dollar coin made of 90% silver would have to be somewhat smaller than a traditional U.S. dime in order for the coin to be manufactured and put into circulation with a reasonable seigniorage. A gold U.S. dollar coin would have to be close to an order of magnitude smaller. Thus, under the conditions prevailing today, gold and silver cannot, as a practical matter, be used for coinage values of a U.S. dollar or so.

In view of the foregoing, it has been proposed to mint coins of large denomination, e.g. a U.S. or Canadian dollar, which have a base of white metal such as nickel or cupro-nickel and a gold colored surface. In U.S. Patent Ho. 4,505,060 it is disclosed that a suitable gold-colored coin could be made by electrodepositing a very thin layer of gold upon a nickel surface and metallurgically interdiffusing the gold and nickel to form an alloy at the coin surface of about 98% gold-2% nickel with the nickel content of the alloy increasing toward the gold-nickel interface. It is believed that a coin made in such a fashion is practical. However, it was decided that the cost of making a Canadian dollar in this fashion using a nickel base on which gold was deposited was too high.

The present invention is concerned with the manufacture of an alternative gold-colored coin which owes its color to titanium nitride (TiN) thus avoiding the intrinsic cost of gold metal. In initially trying to carry out the simple idea of coating a coin, say, the Susan B. Anthony U.S. dollar with a one micrometer thick layer of TiN, it was found that a very good looking gold colored coin could be made using ordinary techniques of the arc plasma process for coating with TiN. However, despite the intrinsically high hardness of the TiN, the wear resistance of the initially coated coins was very poor. We determine wear resistance of coins by placing 70 to 80 grams of coins in a cloth bag and continuously tumbling that bag in a drum rotating at about 32 rpm (i.e. a linear speed of about 15 m/minute). This test is continued for 14 days with weight loss being measured and facial appearance noted every two days or so. It has been determined that pure nickel coins in ordinary circulation lose about 0.1 to about 0.2 milligrams (mg) per gram of weight per year of circulation. J.C. Corkery, Master of the Royal Canadian Mint has noted that the Canadian dollar coin should have a useful life in normal circulation of about 25 years. Given the historic loss of weight per year for coins such as the Canadian quarter we have concluded, on a numerical basis that our wear test represents 18 to 20 years of normal circulation. However, with a coin having a surface of different color than the base, the numbers do not tell the whole story. If a major portion of the wear is at high spots on the coin design, the coin will rapidly become unattractive. A nose or a forehead of a head design showing the white color of the base with the remainder of the head being of golden color makes the coin aesthetically undesirable even though the actual wear is very small. In the case of TiN deposited directly on the Susan B. Anthony U.S. dollar coins, highlight wear was very rapid and overall wear represented by a numerical value, e.g. about 0.35 mg/g/yr was just about the same as the wear of an uncoated Susan B. Anthony U.S. dollar.

It is an object of the present invention to provide a process for producing coins, tokens, medals and the like which are readily distinguished from similar objects made of white-colored metal and which are practically totally resistant to the detrimental effects of normal wear and corrosion over the normal coin lifetime.

STATEMENT OF INVENTION

The present invention comprises a process for producing a disc-like object such as a token or a coin which comprises providing a disc-like metal object bearing an imprint and having on at least a portion of the surface thereof a layer of hard nickel and/or cobalt and/or chromium and arc plasma plating on said nickel and/or cobalt and/or chromium surface an adherent layer of titanium nitride about 0.5 to about 2 micrometers thick while maintaining the temperature of said disc-like object above about 180°C. When, as is advantageous, the intermediate layer is an electrodeposited "bright" nickel, the temperature of the disc-like object should not exceed about 430°C. Advantageously the entire surface of the disc-like object is overlayed by a hard coating of nickel and/or cobalt and/or chromium and coating with TiN is carried out on both sides simultaneously. The invention also contemplates the product produced by said process, i.e. a disc-like object bearing an imprint, having on the surface thereof in sequence a layer of nickel and/or cobalt and/or chromium and on the outer surface a layer of titanium nitride about 0.5 to about 2 micrometers thick.

DRAWINGS

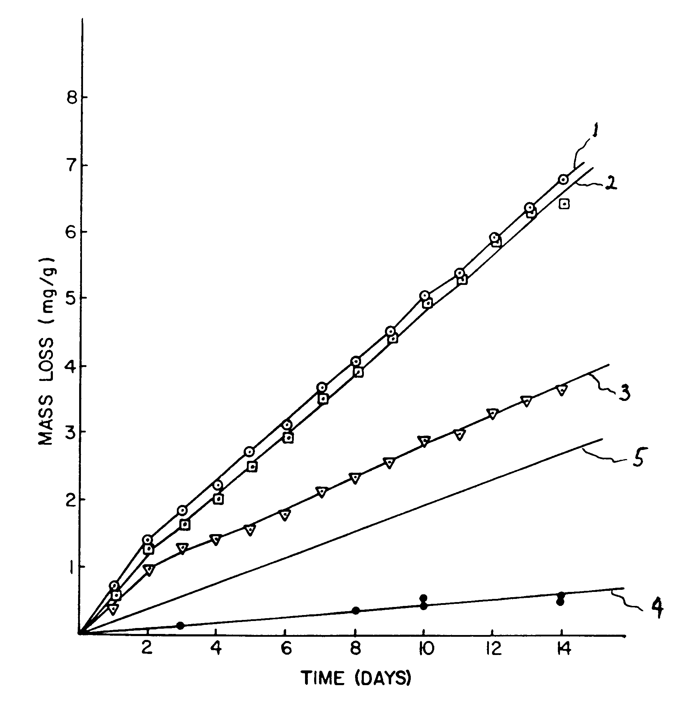

The figure of the drawing is a graph depicting the interrelationship of unit weight loss versus time for various types of coins and coatings.

GENERAL DESCRIPTION OF THE INVENTION

In carrying out the process of the present invention it appears that a number of interrelated factors must be taken into account. These factors include:
1. obtaining a good bond between the hard metal deposit and the coin base;
2. depositing enough hard metal to achieve the results required but not so much as to either obscure the design on the token or coin or to become inherently unstable,
3. obtaining a good bond between the metal deposit and the TiN; and
4. depositing sufficient TiN to achieve the coloration and wear resistance required.
This description will discuss these factors in turn.

It is within the contemplation of the invention to deposit a hard metal coating on a token or coin either electrolytically or non-electrolytically. Regardless of which method is used, the surface which is being coated must be scrupulously cleaned in the manner conventional to the electroplating art. In this regard it is recommended that the cleaning procedures outlined in Chapters 3E, 3F and 3G of Electroplating Engineers Handbook, Graham, 3rd Ed., Reinhold Publishing Corporation, 1971 be followed. Those skilled in the art will recognize that because the present process involves heating a plated object in a high vacuum, any trace of grease, dirt, oxide or the like under the deposit will likely cause defects especially if the contaminant evolves gas at temperatures in excess of about 200°C. Accordingly, rigorous cleaning of the coin or token to be plated is necessary.

Any nickel or cobalt or chromium electroplating bath and process which is designed to produce an electrodeposit having a Vickers Hardness (Hv) of greater than about 450 at specified current densities and temperatures can be used. Some such baths and process conditions are set forth in the Electroplating Engineers Handbook (ibid), for example, on page 246. Many other nickel plating baths are available as proprietary products and are usually described as "bright" baths. Deposits from these "bright" baths can be highly stressed internally. Applicants have found, using a particular proprietary bath, that a deposit thickness of 10 micrometers is satisfactory and that a deposit thickness of 5 micrometers can be used with a slightly increased likelihood of increased rejects due to holidays in the coating. Non-electrolytic, e.g. autocatalytic nickel deposits of the "Kanigen"™ type can also be used. These nickel deposits can contain up to about 10%, e.g. about 5% phosphorus. Regardless of the type of nickel or cobalt or chromium deposited and regardless of the capability of the particular process for producing thick, defect-free coatings, it must be kept in mind that the coin design must not be obscured. Because of this, it is generally recommended that the metal layer be no greater in thickness than 50 micrometers.

Obtaining a good bond between the TiN and the deposited metal layer requires cleaning of the metal surface in the same manner as cleaning the original surface of the token or coin if the metal deposit has been exposed to contamination of even the most minor kind. Thus, a sequence of solvent, e.g. Freon™ degreasing, ultrasonic scrubbing in hot aqueous detergent solution, rinsing and drying in Freon™ vapor can be used. After such a cleaning, the coins or tokens should not be handled even with lint-free gloves. If coins or tokens freshly coated with metal can be transported, without handling to the site of TiN coating, the cleaning operation can be reduced to a single solvent degreasing, rinsing and drying. The thoroughly cleaned coins or tokens are then introduced into an arc plasma coating apparatus such as described in co-pending European patent application No. 88304837.3 entitled Apparatus and Process for Coloring Objects by Plasma Coating filed on May 27, 1988 in the name of INCO LIMITED citing J.A.E. Bell, B.R. Conard, J. Babjak and R.A. Bradford as inventors. Additional background with respect to arc plasma coating apparatuses and processes are contained in U.S. Patents Nos. 3,783,231 Sablev et al, 3,625,848 to Snaper, 3,793,179 to Sablev et al, 4,485,759 to Brandolf, 4,448,799 to Bergman et al and 4,620,913 to Bergman. After drawing a vacuum in the apparatus the TiN coating cycle includes an initial cleaning and heat-up by sputtering at a negative bias of about 1000 V between the coins or tokens to be coated and a stable arc including a titanium cathode. Titanium ions bombard the surface of the hard nickel deposit to remove final traces of impurities such as chemisorbed oxygen and incidentally to dope the nickel surface with titanium. As soon as this sputtering has caused the temperature of the coated coins or tokens to rise to at least about 180°C and, advantageously to at least about 200°C, the bias voltage is dropped to about 300 V or less and nitrogen at low pressure, e.g. 0.4 to 6,66 Pa ($3 \times 10^{-3}$ to $5 \times 10^{-2}$ torr) is introduced into the coating chamber. TiN then starts to deposit on the hard nickel coating and, with an arc current of about 70 amperes, a one micrometer thick coating of titanium nitride can be produced in about 15 minutes. During this time the temperature of the coins or tokens increases. Generally speaking when nickel is used as the intermediate layer between the coin base or substrate and the TiN, the temperature should not be permitted to go above about 400°C and, more advantageously not above about 370°C during coating.

Those skilled in the metallurgical art will appreciate that exposure of a hard nickel deposit (nickel phosphorus deposits excepted) to temperatures in excess of about 250°C will result in softening of the nickel deposit. This softening or annealing of the deposit (and the underlying coin or token surface) is a function of both time and temperature. Longer times at lower temperatures can be equivalent in softening effect to shorter times at higher temperatures. It has been noticed occasionally that increase in annealing time at a specific temperature can slightly increase the hardness of an electrodeposit of "bright" nickel compared to the hardness of the deposit annealed for a very short time. Thus, in the process of physical vapor depositing of TiN on a nickel plated substrate, the hardness of the nickel plated layer is generally decreased providing a product with a TiN surface and an annealed intermediate layer of electrodeposited nickel.

Various examples both within and without the ambit of the present invention will now be discussed. In this discussion hardnesses are set forth. Those skilled in the art will appreciate that these hardnesses are Vickers diamond pyramid microhardnesses (Hv) determined with a 15 gram load in a direction normal to the substrate surface. The substrates are of the order of 1 millimeter thick; the nickel deposits are 10±2 micrometers thick and the TiN coatings are about 1 micrometer thick except where otherwise noted. For convenience in reporting this data, it is to be understood that all substrates have been thoroughly cleaned as discussed hereinbefore; all nickel deposits have been made with a "bright" nickel electroplating bath containing saccharine and 1, 4 butyne diol as brighteners; and all TiN coatings have been deposited in a low pressure nitrogen atmosphere using arc-plasma apparatus after plated substrates have been thoroughly cleaned and then sputtered with titanium ions in vacuum.

Susan B. Anthony U.S. dollar coins having a 10 micrometer electrodeposited coating of "bright" nickel were tested for hardness both directly after plating and after annealing. The results of these tests are set forth in the following Table:

TABLE

| Test | Annealing | | Avg. Hardness, Hv |
|---|---|---|---|
| | Temp., °C | Time, min | |
| 1 | -- | -- | 610 |
| 2 | 316 | 10 | 330 |
| 3 | 371 | 10 | 284 |
| 4 | 427 | 10 | 291 |
| 5 | 482 | 10 | 280 |
| 6 | 371 | 30 | 360 |
| 7 | 371 | 60 | 331 |
| 8* | -- | -- | 170 |

*Test 8 sets forth the average hardness of the flat surfaces of the Susan B. Anthony U.S. dollar coins without nickel plating and without anneal. The variation in hardnesses making up this average is wide due to uneven cold working of the metal during coining.

The foregoing Table shows that it is to be expected that in the heating attendant physical vapor deposition of TiN layer of bright nickel on a Susan B. Anthony coin will decrease in hardness from the vicinity of 600 Hv to the vicinity of 300 Hv.

Numbers of Susan B. Anthony coins having a 10 micrometer deposit of bright nickel thereon of presumed hardness as in Test 1, i.e. in the range of about 590 Hv to about 620 Hv were coated with TiN in an apparatus basically supplied by Multi-Arc Vacuum Systems, Inc. of St. Paul, Minnesota, USA 55101 modified as disclosed in aforementioned co-pending Canadian application Serial No. 538,430. In this apparatus after vacuum is drawn arcs are struck between titanium cathodes and anodes at a voltage of about 20 volts and an amperage in the vicinity of 70 amperes. Coins mounted in an oscillating rack between at least two arc sources are initially given a negative potential of about 1000 V. This causes titanium ions released from the cathode to bombard the coins, sputter clean the coin surfaces and dope the nickel surface with titanium. After a few minutes of sputtering during which the coins heat up to about 200°C, the bias voltage is lowered from -1000 V to about -400 V and nitrogen at a pressure of about 4 Pa (30 m TORR) is admitted to the coating chamber. The result of these steps is to cause initiation of coating of the nickel-plated coin surfaces with TiN. After about 0.1 micrometer of TiN is deposited, the bias voltage is lowered again to about -250 V and deposition is continued until about 1 micrometer of TiN is deposited. During this time the bias voltage and the arc amperage are adjusted so as to maintain the coin temperature in the range about 288°C to about 427°C. Coins produced in this fashion have a hardness (tested as described hereinbefore) of at least about 1000 Hv.

Reference is made to the drawing which is a graph showing cumulative mass loss in milligrams per gram of coins as a function of wear test time in days. Curve 1 indicates the average wear of a Susan B. Anthony U.S. dollar coin. Curve 2 indicates the average wear of a Susan B. Anthony U.S. dollar coin coated directly with a 1 micrometer layer of TiN. Curve 3 indicates the average wear of a pure nickel Canadian quarter coin. Curve 4 indicates the average wear of a Susan B. Anthony U.S. dollar coin coated with 10 micrometers of bright nickel and 1 micrometer of TiN. Curve 5 indicates the wear rate of a Canadian quarter directly coated with TiN. The drawing shows, from strictly a wear rate point of view that TiN directly coated on a Susan B. Anthony U.S. dollar does not improve the wear resistance of that coin. Assuming that the U.S. government was satisfied with that wear resistance, the numerical wear rate would indicate satisfactory performance of the directly plated, gold colored coin. However, visual inspection of the coins of Curve 2 showed severe highlight and edge wear as early as 3 or 4 days in test. Conversely with the coins in which bright nickel was electrodeposited prior to TiN coating, essentially no wear, highlight or otherwise occurred over the test period (Curve 4). Curve 3 is included to show that a coin made of nickel is intermediate in wear resistance between a cupro-nickel clad coin, i.e. the Susan B. Anthony U.S. dollar and the substantially wear-resistant nickel plated, TiN coated coin of the present invention. Surprisingly, as shown by a comparison of the differences between Curve 3 and Curve 5, directly coating a nickel coin such as the Canadian quarter with TiN does not improve its wear resistance as significantly as the improvement given by applying TiN over a hard nickel electrodeposit on a cupro-nickel faced coin.

**Claims**

1. A process for producing a gold-colored disc-like object comprising providing a disc-like metal substrate bearing an imprint on at least one major surface thereof, depositing on said disc-like metal substrate a layer metal selected from the group of hard nickel, hard cobalt, chromium and alloys thereof in a thickness insufficient to obscure said imprint and thereafter arc plasma plating an adherent layer of TiN about 0.5 to about 2 micrometers thick on the surface of said metal of said group while maintaining said coated substrate at a temperature in the range above about 180°C and, when the deposited metal is hard nickel, below about 430°C.

2. A process as in claim 1 wherein said layer of metal from said group is deposited by electroplating.

3. A process as in claim 2 wherein said electrodeposited metal is bright nickel having an as-plated hardness in excess of about 450 Hv.

4. A process as in claim 1 wherein said disc-like metal substrate is a cupro-nickel clad coin.

5. An article of manufacture comprising a disc-like metal substrate bearing an imprinted indicium, an intermediate layer of electrodeposited metal from the group of nickel, cobalt, chromium and alloys thereof and an adherent surface of TiN about 0.5 to about 2 micrometers thick, said intermediate layer and said TiN together being of insufficient thickness to obscure said imprinted indicium.

6. An article as claimed in claim 5, wherein the substrate is made of cupro-nickel.

**Patentansprüche**

1. Verfahren zum Herstellen eines goldfarbenen scheibenartigen Produkts mit einem scheibenartigen metallischen Träger, einer Prägung auf mindestens einer der Hauptflächen, bei dem auf den Träger eine Metallschicht aus der Gruppe Hartnickel, Hartkobalt, Chrom und deren Legierungen mit einer für ein Undeutlichwerden der Prägung nicht ausreichenden Dicke aufgebracht und die Metallschicht alsdann mit einer etwa 0,5 bis etwa 2 μm dicken haftenden TiN-Schicht plasmaplattiert und dabei das mit der Metallschicht versehene Substrat auf einer Temperatur über etwa 180°C und im Falle einer Hartmetallschicht unter etwa 430°C gehalten wird.

2. Verfahren nach Anspruch 1, dadurch gekennzeichnet, daß die Metallschicht durch Elektroplattieren aufgebracht wird.

3. Verfahren nach Anspruch 2, dadurch gekennzeichnet, daß auf den Träger eine Glanznickelschicht mit einer Härte über etwa 450 HV im plattierten Zustand aufgebracht wird.

4. Verfahren nach Anspruch 1, dadurch gekennzeichnet, daß der Träger aus einer mit Kupfer-Nickel plattierten Münze besteht.

5. Produkt mit einem scheibenartigen Metallsubstrat, einer Prägung, einer durch Elektroplattieren aufgebrachten Zwischenschicht aus einem Metall der Gruppe Nickel, Kobalt, Chrom und deren Legierungen sowie einer haftenden Oberfläche aus TiN mit einer Dicke von etwa 0,5 bis etwa 2 μm sowie einer für ein Undeutlichwerden der Prägung nicht ausreichenden Gesamtdicke der Zwischen- und TiN-Schicht.

6. Produkt nach Anspruch 5, bei dem der Träger aus Kupfer-Nickel besteht.

**Revendications**

1. Un procédé pour la fabrication d'un objet couleur or semblable à un disque comprenant le fait de fournir un substrat métallique semblable à un disque portant une empreinte sur au moins une de ses surfaces principales, de déposer sur ledit substrat métallique semblable à un disque un métal en couche sélectionné à partir du groupe composé du nickel dur, du cobalt dur, du chrome et des alliages de ceux-ci, avec une épaisseur n'étant pas suffisante pour obscurcir ladite empreinte, puis consistant ensuite à plaquer par plasma à l'arc une couche adhérente de TiN d'une épaisseur d'environ 0,5 à environ 2 micromètres sur la surface dudit métal appartenant audit groupe, tout en maintenant ledit substrat revêtu à une température de l'ordre d'environ plus de 180°C et, lorsque le métal déposé est du nickel dur, inférieure à environ 430°C.

2. Un procédé selon la revendication 1, dans lequel ladite couche de métal appartenant audit groupe est déposée par placage.

3. Un procédé selon la revendication 2, dans lequel ledit métal déposé par électrolyse est du nickel brillant ayant une dureté tel que plaqué supérieure à environ 450 Hv.

4. Un procédé selon la revendication 1, dans lequel ledit substrat métallique semblable à une disque est une pièce recouverte de cupronickel.

5. Un article fabriqué comprenant un substrat métallique semblable à un disque portant un indice gravé, une couche intermédiaire de métal déposé par électrolyse à partir du groupe du nickel, du cobalt, du chrome et des alliages de ceux-ci, et une surface adhérente de TiN d'une épaisseur d'environ 0,5 à environ 2 micromètres, ladite couche intermédiaire et ledit TiN pris ensemble ayant une épaisseur insuffisante pour obscurcir ledit indice gravé.

6. Un article selon la revendication 5, dans lequel le substrat est fabriqué en cupronickel.